(19) Europäisches Patentamt
European Patent Office
Office européen des brevets

(11) EP 3 929 334 A1

(12) **EUROPÄISCHE PATENTANMELDUNG**

(43) Veröffentlichungstag:
29.12.2021 Patentblatt 2021/52

(51) Int Cl.:
*C30B 15/00* (2006.01)   *C30B 29/06* (2006.01)
*C30B 33/02* (2006.01)

(21) Anmeldenummer: 20181650.1

(22) Anmeldetag: 23.06.2020

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(71) Anmelder: **Siltronic AG**
**81677 München (DE)**

(72) Erfinder:
• **Müller, Timo**
  **84489 Burghausen (DE)**
• **Gehmlich, Michael**
  **09600 Weißenborn (DE)**
• **Mangelberger, Karl**
  **5122 Ach (AT)**
• **Skrobanek, Michael**
  **09599 Freiberg (DE)**
• **Kissinger, Gudrun**
  **15326 Lebus (DE)**

(54) **VERFAHREN ZUR HERSTELLUNG VON HALBLEITERSCHEIBEN**

(57)    Verfahren zur Herstellung einer Halbleiterscheibe aus einkristallinem Silizium, umfassend das Bereitstellen einer Substratscheibe aus einkristallinem Silizium, die interstitiellen Sauerstoff mit einer Konzentration mehr als $5 \times 10^{16}$ AT/cm$^3$ (new ASTM) enthält; eine RTA-Behandlung der Substratscheibe enthaltend eine erste Wärmebehandlung der Substratscheibe bei einer ersten Temperatur in einem Temperaturbereich von nicht weniger als 1200 °C und nicht mehr als 1260 °C für einen Zeitraum von nicht weniger als 5 s und nicht mehr als 30 s, wobei eine Vorderseite der Substratscheibe einer Atmosphäre enthaltend Argon ausgesetzt wird, eine zweite Wärmebehandlung der Substratscheibe bei einer zweiten Temperatur in einem Temperaturbereich von nicht weniger als 1150 °C und nicht mehr als 1190 °C für einen Zeitraum von nicht weniger als 15 s und nicht mehr als 20 s, wobei eine Vorderseite der Substratscheibe einer Atmosphäre enthaltend Argon und Ammoniak ausgesetzt wird, und eine dritte Wärmebehandlung der Substratscheibe bei einer dritten Temperatur in einem Temperaturbereich von nicht weniger als 1160 °C und nicht mehr als 1190 °C für einen Zeitraum von nicht weniger als 20 s und nicht mehr als 30 s, wobei eine Vorderseite der Substratscheibe einer Atmosphäre enthaltend Argon ausgesetzt wird.

Figur 1

EP 3 929 334 A1

**Beschreibung**

Gegenstand der Erfindung ist ein Verfahren zur Herstellung einer Halbleiterscheibe aus einkristallinem Silizium umfassend einen Hochtemperaturschritt.

Monokristalline Halbleiterscheiben (auch Wafer genannt) sind die Grundlage der modernen Elektronik. Während der Herstellung von Bauelementen auf besagten Halbleiterscheiben werden thermische Prozesse mit mittlerweile recht komplexen Beschichtungsschritten durchgeführt.

Halbleiterscheiben werden üblicherweise gewonnen, indem aus einem Einkristall Scheiben mittels einer Innenloch- oder Drahtsäge (MWS) geschnitten und anschließend Schleif- und/oder Polierschritte und optional ein Epitaxieschritt durchgeführt werden.

Wird der Einkristall, von dem die Halbleiterscheibe stammt, gemäß der Czochralski-Methode (CZ-Methode) aus einer Schmelze gezogen, die in einem Quarztiegel gehalten wird, bildet das Tiegelmaterial die Quelle für interstitiellem Sauerstoff, der in den Einkristall und die daraus gewonnene Halbleiterscheibe eingebaut wird. Die Konzentration an interstitiellem Sauerstoff, die eingebaut wird, lässt sich recht genau kontrollieren, beispielsweise durch die Regelung des Drucks und des Durchflusses von Argon durch die Ziehapparatur oder durch das Abstimmen von Tiegel- und Keimkristalldrehung während des Ziehens des Einkristalls oder durch Anwendung eines Magnetfelds, das der Schmelze aufgeprägt wird, oder durch eine Kombination dieser Maßnahmen. Im Allgemeinen ist die gemessene interstitielle Sauerstoffkonzentration bei Kristallen, die nach der CZ Methode hergestellt wurden nicht kleiner als 5 x $10^{16}$ AT/cm$^3$ (new ASTM).

Besondere Bedeutung beim Ziehen eines Einkristalls aus Silizium gemäß der CZ-Methode hat auch die Kontrolle des Verhältnisses v/G von Ziehgeschwindigkeit v und axialem Temperaturgradienten G an der Kristallisationsgrenze. Die Ziehgeschwindigkeit v ist die Geschwindigkeit, mit der der wachsende Einkristall von der Schmelze weg nach oben gehoben wird, und der axiale Temperaturgradient G ist ein Maß, das die Änderung der Temperatur an der Kristallisationsgrenze in Richtung des Kristallhubs anzeigt. Art und Konzentration von Punktdefekten (Leerstellen und Silizium-Zwischengitteratome), die im Einkristall dominieren, werden wesentlich vom Quotienten v/G bestimmt.

BMDs lassen sich besonders in einem Gebiet entwickeln, in dem die Anzahl an Leerstellen diejenige an Silizium-Zwischengitteratomen übersteigt und in dem deshalb Leerstellen dominieren. Ist beim Kristallisieren des Einkristalls eine vergleichsweise hohe Übersättigung an Leerstellen vorhanden, was bei vergleichsweise hohem Quotienten v/G der Fall ist, bilden die Leerstellen Agglomerate, die beispielsweise als COPs (Crystal Originated Particles) nachgewiesen werden können. Ist v/G und damit die Übersättigung der Leerstellen etwas geringer als es zur Bildung von COPs notwendig wäre, bilden sich anstelle von COPs Keime von OSF-Defekten (Oxidation Induced Stacking Faults). In diesem Fall kristallisiert der Einkristall im OSF-Gebiet. Ist der Quotient v/G noch kleiner, entsteht beim Kristallisieren des Einkristalls ein Gebiet, in dem Leerstellen noch dominieren, das aber als defektfrei gilt, weil darin COPs und OSFs nicht gebildet werden. Ein solches Gebiet wird $P_v$-Gebiet genannt. Bei weiterem Absenken des Quotienten v/G wächst der Einkristall im $P_i$-Gebiet, das ebenfalls als defektfrei gilt, in dem aber Silizium-Zwischengitteratome dominieren.

Der axiale Temperaturgradient G an der Kristallisationsgrenze und dessen radialer Verlauf werden bestimmt durch den Wärmetransport von und zur Kristallisationsgrenze. Der Wärmetransport wird wiederum wesentlich beeinflusst durch die thermischen Eigenschaften der Umgebung des wachsenden Einkristalls, der sogenannten "hot zone", und durch die Wärmezufuhr durch eine oder mehrere Heizvorrichtungen.

Ist die Entscheidung gefallen, einen Einkristall in einer bestimmten hot zone zu ziehen, kann der axiale und radiale Verlauf des axialen Temperaturgradient G an der Kristallisationsgrenze mittels Simulationsrechnungen, die die Wärmebilanz berücksichtigen, bestimmt werden. Durch eine entsprechende Gestaltung der hot zone kann auch dafür gesorgt werden, dass der axiale Temperaturgradient G entlang des Radius des Einkristalls einen angestrebten Verlauf hat. Durch das Wachsen des Einkristalls und die Abnahme des Volumens der Schmelze verändern sich mit der Zeit die thermischen Verhältnisse und damit auch der axiale Verlauf des axialen Temperaturgradienten G an der Kristallisationsgrenze. Um den Quotienten v/G auch in axialer Richtung in einem vorgesehenen Bereich zu halten, ist es deshalb erforderlich, die zeitliche Änderung des axialen Temperaturgradienten G durch eine entsprechende Änderung der Ziehgeschwindigkeit v zu kompensieren.

Durch das Kontrollieren der Ziehgeschwindigkeit v kann also auch der Quotient v/G kontrolliert werden.

WO 98/45508 A1 ist eine von zahlreichen Veröffentlichungen, die beschreiben, wie der zeitliche Verlauf der Ziehgeschwindigkeit v experimentell ermittelt werden kann, um über die Kontrolle der Ziehgeschwindigkeit v zu erreichen, dass der Quotient v/G während des Wachstums des Einkristalls nahezu unverändert bleibt und der Einkristall in einem vorgesehenen Gebiet wachsen kann. Darüber hinaus sind Nachweismethoden zur Charakterisierung und Unterscheidung von $P_v$-Gebiet und $P_i$-Gebiet beschrieben.

Der interstitielle Sauerstoff im Kristall spielt eine wichtige Rolle bei der Bildung von BMD-Defekten (BMDs, Bulk Micro Defects). BMDs sind Sauerstoffpräzipitate, zu denen BMD-Keime im Zuge einer Wärmebehandlung wachsen. Sie wirken als interne Getter, also als energetische Senken für Verunreinigungen, und sind daher grundsätzlich von Vorteil. Eine Ausnahme bildet ihre Präsenz an Stellen, an denen beabsichtigt ist, elektronische Bauelemente unterzubringen. Um zu vermeiden, dass BMDs an solchen Stellen entstehen, kann zum Beispiel eine epitaktische Schicht auf der Halbleiterscheibe abgeschieden und vorgesehen werden, die elektronischen Bauelemente in der epitaktischen Schicht unterzubringen. Es kann aber auch die Halbleiterscheibe einer thermischen Behandlung unterzogen werden, so dass interstitieller Sauerstoff an die Oberfläche der Halbleiterscheibe ausdiffundiert und so im oberflächennahen Bereich keine BMDs ausbilden kann. Dieser Bereich wird "denuded Zone" genannt.

Eine denuded Zone ist demnach ein Bereich der Halbleiterscheibe, der sich von der Vorderseite in Richtung der Rückseite über eine bestimmte Tiefe erstreckt und in dem BMDs nicht gebildet werden können.

An die denuded Zone grenzt ein weiterer ins Innere ("Bulk") der Halbleiterscheibe reichender Bereich an, in dem BMD-Keime vorhanden sind.

Es ist bekannt, dass die Gegenwart von Leerstellen im Einkristall vorteilhaft ist, wenn vergleichsweise hohe Dichten an BMDs angestrebt werden. In der US 2002/0170631 A1 ist ein Verfahren zur Herstellung einer Halbleiterscheibe aus einkristallinem Silizium mit einer tiefen denuded Zone beschrieben. Das Verfahren umfasst eine Wärmebehandlung (RTA-Behandlung, rapid thermal anneal) der Halbleiterscheibe, die ein kurzzeitiges schnelles Erhitzen und Abkühlen der Halbleiterscheibe beinhaltet. Die RTA-Behandlung soll in einer Atmosphäre durchgeführt werden, die Sauerstoff in einer Konzentration von nicht weniger als 100 ppma und nicht mehr als 10 000 ppma enthält. Darüber hinaus ist das beschriebene Verfahren so konzipiert, dass ein Konzentrationsprofil von Leerstellen entsteht, bei dem die Spitzendichte an Leerstellen in der Mitte zwischen der Vorderseite und der Rückseite der Halbleiterscheibe erreicht wird oder nahe der Mitte. Da die Konzentrationsprofile der Leerstellen, der BMD-Keime und der BMDs korrelieren, wird die Spitzendichte an BMDs ebenfalls in der Mitte oder nahe der Mitte gefunden.

Die EP 1 887 110 A1 beschreibt die Herstellung einer Halbleiterscheibe aus einkristallinem Silizium, die Sauerstoff, Stickstoff und Wasserstoff enthält und von einem Einkristall stammt, der im $P_v$-Gebiet gezogen wurde. Es wird berichtet, dass die Gegenwart von Stickstoff und in geringerem Maße die von Wasserstoff ermöglicht, einen größeren Bereich an Ziehgeschwindigkeiten nutzen zu können, um den Einkristall im $P_v$-Gebiet kristallisieren zu können. Darüber hinaus wird vorgeschlagen, die Konzentration an interstitiellem Sauerstoff in der Halbleiterscheibe vergleichsweise hoch zu wählen und die Halbleiterscheibe einer Wärmebehandlung mittels RTA zu unterziehen.

Die Patentschrift DE 10 2017 219 255 A1 beschreibt ein Verfahren zur Herstellung von Halbleiterscheiben, das zwei RTA Behandlungen beinhaltet. Die auf diese Weise hergestellten Halbleiterscheiben zeigen eine Denuded Zone von nicht weniger als 30 $\mu$m und weisen BMD Keime auf, die sich zu BMDs entwickeln lassen, deren Dichte im Abstand von mindestens zur 120 $\mu$m zur Vorderseite der Halbleiterscheibe von nicht weniger als 3 x 10⁹ cm⁻³ beträgt.

Die wissenschaftliche Veröffentlichung von Müller et al. (T. Müller et al., "Near-Surface Defect Control by Vacancy Injecting/Out-Diffusing Rapid thermal Annealing", Phys. Status Solidi A, 2019, 1900325) beschreibt Wirkung von unterschiedlichen Atmosphären bei RTA Schritten mit unterschiedlichen Temperaturen auf Kristalldefekte.

Die Patentschrift DE 10 2016 225 138 A1 offenbart ein Verfahren, das drei RTA Schritte enthält, wobei zwischen den ersten beiden RTA Schritten ein Ätzschritt durchgeführt wird, der geeignet ist, ein Oxid der Oberfläche der Halbleiterscheibe zu entfernen.

Das darin vorgeschlagene Verfahren weist Nachteile auf. Der notwendige Ätzschritt; um die beim ersten RTA-Schritt entstehende Oxidschicht zu entfernen; ist teuer und stellt ein zusätzliches Risiko einer Kontamination der Halbleiterscheiben dar. Zudem stellt das vorgeschlagene Verfahren an das eingesetzte Material erhöhte Anforderungen, da der für die Halbleiterscheiben verwendete der Stab komplett im $P_v$-Gebiet liegen muss. Stabstücke, die nicht diese Anforderungen erfüllen, müssen dabei verworfen werden.

Wenn das für das vorgeschlagene Verfahren eingesetzte Substrat neben einem $P_v$-Gebiet auch noch ein $P_i$-Gebiet aufweist, zeigt sich, dass die radiale Homogenität der Eigenschaften der Halbleiterscheibe nicht mehr den Ansprüchen genügen.

Wenn das eingesetzte Substrat ein Gebiet enthält, in dem kleine COPs nachzuweisen sind, ergibt sich das Problem, dass die radiale Homogenität der gewünschten Eigenschaften der Halbleiterscheibe ungenügend ist. Dasselbe gilt für den Fall, dass es sowohl zusätzlich ein $P_i$-Gebiet und auch ein Gebiet, in dem kleiner COPs nachweisbar sind.

Die angeführten Nachteile sind maßgeblich dafür, dass das Verfahren zum Ziehen eines Einkristalls, der für das Gewinnen des Substrats notwendig ist, aufwändiger und damit teurer ist.

Aufgabe der vorliegenden Erfindung ist es also, ein Alternativverfahren bereitzustellen, das die Nachteile des in der DE 10 2016 225 138 A1 genannten Verfahrens nicht aufweist, gleichzeitig mindestens dieselben Eigenschaften der beschriebenen Halbleiterscheibe hervorruft.

Die Aufgabe der Erfindung wird gelöst durch die in den Ansprüchen beschriebenen Verfahren.

## Kurzbeschreibung der Figuren

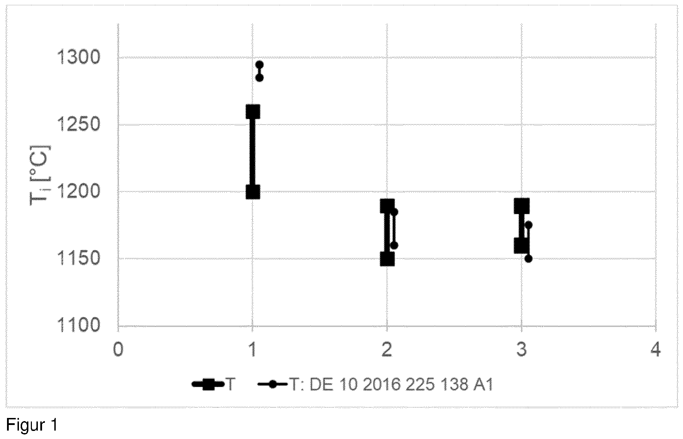

**Figur 1** zeigt den Temperaturbereich des jeweiligen i-ten RTA-Schrittes, wobei die Abszisse den Index i des jeweiligen RTA-Schrittes wiedergibt. T bezeichnet dabei die einzelnen Temperaturen des erfindungsgemäßen Verfahrens, während im Vergleich dazu T: DE 10 2016 225 138 A1 die Temperaturen eines Verfahrens des Standes der Technik wiedergibt.

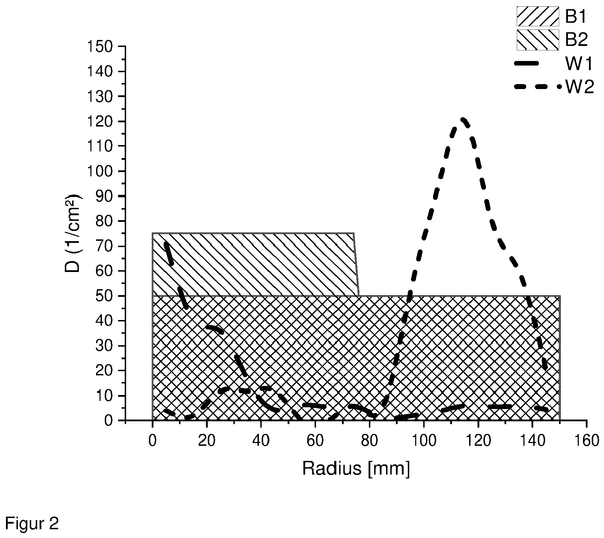

**Figur 2** zeigt die radiale Verteilung der Defekte nach thermischer Behandlung einer Testscheibe. Die Bereiche B1 und B2 geben die für die Erfindung bevorzugten Bereiche wieder, in der sich eine Testscheibe befinden muss, um für den thermischen Prozess geeignet zu sein. W1 und W2 geben radiale Defektdichten von zwei unterschiedlichen Testscheiben wieder, wobei W1 den Anforderungen genügt und W2 nicht.

**Detaillierte Beschreibung erfindungsgemäßer Ausführungsbeispiele**

Die erfindungsgemäße Herstellung einer Halbleiterscheibe aus einkristallinem Silizium umfasst das Züchten eines Einkristalls nach der CZ-Methode, das Ablängen von Kristallstücken zusammen mit dem Herstellen mindestens einer Testscheibe aus dem jeweiligen Kristallstück, das Abtrennen von Substratscheiben von einem Kristallstück und die Weiterverarbeitung der Substratscheiben zu Halbleiterscheiben.

Eine für die Erfindung notwendige Eigenschaft der gewonnenen Substratscheiben ist, dass Sauerstoff mit einer Konzentration von mehr als $5 \times 10^{16}$ At/cm$^3$ (new ASTM) enthalten ist. Dabei ist es nicht zwangsweise erforderlich, dass die CZ -Methode verwendet wird.

Die Weiterverarbeitung der Substratscheiben zu Halbleiterscheiben umfasst vorzugsweise die mechanische Bearbeitung der vom Einkristall abgetrennten Substratscheiben durch Läppen und/oder Schleifen, das Entfernen oberflächennaher beschädigter Kristallbereiche durch Ätzen und eine Vorreinigung der Substratscheiben in SC1-Lösung, SC2-Lösung und Ozon.

Beim Züchten des Einkristalls wird die Schmelze vorzugsweise mit einem Magnetfeld beaufschlagt, besonders bevorzugt mit einem horizontalen Magnetfeld oder mit einem CUSP-Magnetfeld. Der Quotient v/G von Ziehgeschwindigkeit v und axialem Temperaturgradienten G an der Phasengrenze wird derart geregelt, dass die Halbleiterscheibe aus einkristallinem Silizium, die durch Weiterverarbeiten des Einkristalls erhalten wird, entweder vollständig aus $P_i$-Gebiet besteht, oder zusätzlich ein $P_v$-Gebiet enthält.

Die Ziehgeschwindigkeit v beim Züchten des Einkristalls beträgt vorzugsweise nicht weniger als 0,45 mm/min, sofern die Herstellung von Halbleiterscheiben mit einem Durchmesser von 300 mm beabsichtigt ist.

Die optimale Ziehgeschwindigkeit beim Ziehen kann dadurch gefunden werden, dass die Ziehgeschwindigkeit an einem Kristallstück mit zunehmender Länge des Kristalls variiert wird. Aus dem so erhaltenen Kristallstück kann mittels zweier Längsschnitte, die entlang des Zentrums des Kristallstückes geführt werden, eine rechteckige Scheibe (ein sogenanntes Brett) herausgeschnitten werden, so dass die Position auf einer Seite der rechteckigen Scheibe dabei der verwendeten Ziehgeschwindigkeit entspricht. Analysiert man die Scheibe, so können Defekteigenschaften genau einer Ziehgeschwindigkeit zugeordnet werden und so die gewünschte Ziehgeschwindigkeit gefunden werden.

Ein Einkristall wächst vorzugsweise in einer Atmosphäre aus Argon oder, besonders bevorzugt, in einer Atmosphäre, die Argon und Wasserstoff enthält. Der Partialdruck an Wasserstoff ist besonders bevorzugt kleiner als 30 Pa. Der Partialdruck berechnet sich hierbei unter der Annahme eines idealen Gases nach dem Daltonschen Gesetz. Hierbei soll gelten:

$$\frac{n_i}{n_{ges}} = \frac{p_i}{p_{ges}}$$

Wobei $n_i$ die Stoffmenge der i-ten Komponente, $n_{ges}$ die Gesamtstoffmenge, $p_{ges}$ den Druck und $p_i$ den Partialdruck der i-ten Komponente darstellt.

Die vom Einkristall erhaltenen Substratscheiben aus einkristallinem Silizium hat eine Konzentration an Sauerstoff von nicht weniger als $4,5 \times 10^{17}$ Atome/cm$^3$ und nicht mehr als $5,2 \times 10^{17}$ Atome/cm$^3$ (new ASTM). Bekanntermaßen kann die Konzentration an Sauerstoff im Einkristall während dessen Herstellung eingestellt werden, beispielsweise über die Regelung der Drehgeschwindigkeit des Tiegels und/oder des Einkristalls und/ oder über die Regelung des Drucks und/oder der Durchflussgeschwindigkeit des Gases, das die Atmosphäre bildet, in der der Einkristall wächst, und/oder über die Regelung der Magnetfeldstärke des Magnetfelds, mit dem die Schmelze beaufschlagt wird.

Ein Laser Tomograph des Typs IR-LST der Fa. SemiLab wurde mit einer Laserleistung von 50-80 mW und einem Defektgrößen-Auflösungsbereich von 20 nm-60 nm verwendet, um an einer Testscheibe die Defektdichte zu bestimmen. War die gemessene Defektdichte auf der gesamten Testscheibe kleiner als $5 \times 10^4$ 1/cm$^3$, wurde davon ausgegangen, dass das zugehörige Kristallstück frei von COPs ist.

Die Erfinder haben erkannt, dass es besonders vorteilhaft ist, wenn Substratscheiben verwendet werden, die nur Sauerstoffpräzipitate beinhalten, die eine Größe von kleiner als 9 nm, vorzugsweise kleiner 6 nm haben. Eine überprüfende Messung kann z. B. mittels TEM (Transmissionselektronenmikroskopie) am Substrat vorgenommen werden.

Das Gebiet auf der Substratscheibe, das Keime von Sauerstoffpräzipitaten beinhaltet, wird im Weiteren als $P_{bmd}$-Gebiet bezeichnet.

Die Erfinder haben als Test für das Auftreten solcher Sauerstoffpräzipitate mit den beschriebenen Eigenschaften folgendes Verfahren durchgeführt.

Eine Testscheibe wird unter einer N$_2$ Atmosphäre bei 880-920°C in einen Ofen (horizontal oder vertikal) eingefahren und dort 6-10 Stunden gehalten, danach findet ein Aufheizen bis auf 1080-1120°C statt und eine Nass-Oxidation mit $O_2/H_2$ findet statt für eine Haltezeit von 1,5-2,5 Stunden. Anschließend wird die Testscheibe unter einer reinen $O_2$ Atmosphäre gekühlt. Alle Aufheiz- und Abkühlraten sind im Bereich von 5 - 10 K/min. Danach wird die Testscheibe einer Secco Ätzung mit einem Abtrag von 5 - 10 $\mu$m unterworfen und die auftretenden Defekte mittels eines radial scannenden optischen Mikroskops detektiert und ihre Dichte ermittelt.

Ist die gemessene Defektdichte über die gesamte Vorderseite der Testscheibe kleiner als 50 Defekte/cm$^2$, wird angenommen, dass die eventuell enthaltenen Sauerstoffpräzipitate kleiner als 6 nm sind.

Ist die gemessene Defektdichte in einem Kreis auf der Vorderseite der Testscheibe, der seinen Mittelpunkt mit der Vorderseite der Testscheibe teilt und dessen Radius nicht mehr als 50 mm beträgt, größer als 50 Defekte/cm$^2$ und kleiner als 75 Defekte/cm$^2$ und auf dem Rest der Testscheibe kleiner als 50 Defekte/cm$^2$, wird davon ausgegangen, dass die Größe der eventuell vorhandenen Sauerstoffpräzipitate kleiner ist als 9 nm.

Exemplarisch wurden experimentell erhaltene Defektdichten von zwei Testscheiben W1 und W2 in Figur 2 dargestellt. Testscheibe W1 genügt demnach den Anforderungen und W2 nicht.

Um die Größe der Sauerstoffpräzipitate zu bestimmen, wurden numerische Simulationen analog der Veröffentlichung "Müller et al" durchgeführt, wobei die Randbedingungen entsprechend angepasst wurden.

Zusätzlich haben die Erfinder erkannt, dass die Substratscheiben bevorzugt ein $P_i$-Gebiet aufweisen, in denen Silizium Zwischengitteratome dominieren und diese jedoch noch keine Versetzungsschleifen also keine sogenannte LPITs ausbilden.

Die Messung auf etwaige LPits erfolgte über eine Mikroskopie Auszählung der gefundenen Defekte auf der Oberfläche der Substratscheibe, nachdem zunächst eine Glanzätze (Abtrag 70$\mu$m) und danach eine Secco-Ätze für 16 min durchgeführt wurde.

Bevorzugt haben die Substratscheiben zusätzlich ein $P_v$-Gebiet, in dem Silicium Leerstellen dominieren, diese aber keine Aggregate größer als 10 nm bilden. Dieses Gebiet ist bevorzugt kleiner als 80% der Fläche der Substratscheiben.

Die RTA-Behandlung umfasst ein erstes schnelles Erhitzen der Substratscheiben aus einkristallinem Silizium auf eine Temperatur in einem Temperaturbereich von nicht weniger als 1200 °C und nicht mehr als 1260 °C und das Halten der Substratscheiben in diesem Temperaturbereich über einen Zeitraum von nicht weniger als 5 s und nicht mehr als 30 s. Die erste Wärmebehandlung wird in einer Atmosphäre durchgeführt, die aus Argon enthält und bevorzugt aus Argon besteht.

Die darauffolgende zweite Wärmebehandlung umfasst das schnelle Erhitzen der Substratscheiben aus einkristallinem Silizium auf eine Temperatur in einem Temperaturbereich von nicht weniger als 1150 °C und nicht mehr als 1190 °C und das Halten der Substratscheiben in diesem Temperaturbereich über einen Zeitraum von nicht weniger als 15 s und nicht mehr als 20 s in einer Atmosphäre, die Argon und Ammoniak enthält und vorzugsweise aus Argon und Ammoniak ($NH_3$) besteht.

Die bevorzugte RTA Behandlung ist in Figur 1 schematisch wiedergegeben.

Das Volumen-Verhältnis Ar:$NH_3$ beträgt vorzugsweise nicht weniger als 10:10 und nicht mehr als 10:5, besonders bevorzugt 10:8. Die Durchflussgeschwindigkeit des Gasgemisches durch den RTA-Ofen beträgt vorzugsweise nicht weniger als 2 slm und nicht mehr als 5 slm.

Nach der zweiten Wärmebehandlung in einer Atmosphäre, die Argon und Ammoniak umfasst, wird die Substratscheiben aus einkristallinem Silizium einer dritten Wärmebehandlung bei einer Temperatur in einem Temperaturbereich von nicht weniger als 1160 °C und nicht mehr als 1190 °C über einen Zeitraum von nicht weniger als 20 s und nicht mehr als 30 s in einer inerten Atmosphäre unterzogen, die Argon enthält und bevorzugt aus Argon besteht.

Die Zusammensetzung der Atmosphäre wird während der jeweiligen Wärmebehandlung geändert und die Wärmebehandlung der Substratscheiben bei gleichbleibender Temperatur fortgesetzt.

Als Alternative ist bevorzugt, die Substratscheiben zwischen der zweiten und der dritten Wärmebehandlung zunächst auf nicht weniger als 600 °C abzukühlen, den RTA-Ofen mit Stickstoff zu spülen, bis er frei von Ammoniak ist, und anschließend die Substratscheiben in inerter Atmosphäre auf die Zieltemperatur der dritten Wärmebehandlung zu bringen.

Die Weiterbehandlung der Substratscheiben in der inerten Atmosphäre ist von besonderer Bedeutung, weil damit die Dichte an Leerstellen im Bereich der denuded Zone ausreichend gesenkt und so verhindert wird, dass dort Sauerstoff-Ausscheidungen neu entstehen können.

Das schnelle Erhitzen der Substratscheiben aus einkristallinem Silizium im Zuge der ersten und der zweiten Wärmebehandlung erfolgt ab einer Temperatur von 600 °C bis zur Zieltemperatur vorzugsweise mit einer Geschwindigkeit des Temperaturanstiegs von nicht weniger als 15 K/s, besonders bevorzugt nicht weniger als 25 °K/s.

Im Gegensatz zur gängigen Lehre (Müller et al.), dass eine geringe Konzentration (zum Beispiel 1% $O_2$) von Sauerstoff in der Atmosphäre für den ersten Wärmebehandlungsschritt notwendig sei, um Sauerstoffpräzipitate in der Nähe der Oberfläche (denuded Zone) aufzulösen, konnte der nachteilige Effekt bei fehlendem Sauerstoff während der ersten Wärmebehandlung überaschenderweise nicht beobachtet werden.

Vorteilhaft ist, wenn zwischen dem Beginn der ersten Wärmebehandlung und dem Ende der letzten Wärmebehandlung nicht mehr als 320 s verstreichen. Der Anfang und das Ende der Wärmebehandlung wird dabei als der Zeitpunkt gesehen, bei dem die Substratscheibe die Temperatur von 600°C erreicht.

Nach der RTA-Behandlung wird die Substratscheibe aus einkristallinem Silizium poliert, vorzugsweise mittels DSP (double side polishing), also mittels gleichzeitig erfolgender Politur der oberen und der unteren Seitenfläche, gefolgt von einer Politur einer Orientierungskerbe (notch) der Substratscheiben und einer Politur einer Kante der Substratscheibe. Üblicherweise wird der Bereich der oberen Seitenfläche, der Vorderseite der so erhaltenen Halbleiterscheibe, zum Aufbau elektronischer Bauelemente herangezogen, weshalb eine abschließende Politur der Vorderseite mittels CMP (**c**hemical **m**echanical **p**olishing) besonders bevorzugt ist. Abschließend wird die polierte Halbleiterscheibe vorzugsweise endgereinigt und getrocknet.

Eine nach dem vorstehend beschriebenen Verfahren hergestellte Halbleiterscheibe aus einkristallinem Silizium eignet sich besonders zur Herstellung von elektronischen Bauelementen mit NAND-Logik, auch unter Bedingungen, die ein vergleichsweise geringes thermisches Budget vorsehen. Voraussetzungen für diese Eignung sind eine denuded Zone, die vergleichsweise tief ist, eine hohe elektrische Durchschlagsfestigkeit eines auf der Halbleiterscheibe erzeugten Gateoxids und die Fähigkeit, eine hohe Dichte an BMDs im inneren Bereich der Halbleiterscheibe ausbilden zu können, trotz einer vergleichsweise niedrigen Konzentration an Sauerstoff und trotz eines zur Verfügung gestellten thermischen Budgets zur Erzeugung der BMDs, das vergleichsweise gering ist.

## Patentansprüche

1. Verfahren zur Herstellung einer Halbleiterscheibe aus einkristallinem Silizium, umfassend

   das Bereitstellen einer Substratscheibe aus einkristallinem Silizium,

   die interstitiellen Sauerstoff mit einer Konzentration mehr als $5 \times 10^{16}$ AT/cm$^3$ (new ASTM) enthält;

   eine RTA-Behandlung der Substratscheibe enthaltend eine erste Wärmebehandlung der Substratscheibe bei einer ersten Temperatur in einem Temperaturbereich von nicht weniger als 1200 °C und nicht mehr als 1260 °C für einen Zeitraum von nicht weniger als 5 s und nicht mehr als 30 s,

   wobei eine Vorderseite der Substratscheibe einer Atmosphäre enthaltend Argon ausgesetzt wird,

   eine zweite Wärmebehandlung der Substratscheibe bei einer zweiten Temperatur in einem Temperaturbereich von nicht weniger als 1150 °C und nicht mehr als 1190 °C für einen Zeitraum von nicht weniger als 15 s und nicht mehr als 20 s,

   wobei eine Vorderseite der Substratscheibe einer Atmosphäre enthaltend Argon und Ammoniak ausgesetzt wird,

   und eine dritte Wärmebehandlung der Substratscheibe bei einer dritten Temperatur in einem Temperaturbereich von nicht weniger als 1160 °C und nicht mehr als 1190 °C für einen Zeitraum von nicht weniger als 20 s und nicht mehr als 30 s, wobei eine Vorderseite der Substratscheibe einer Atmosphäre enthaltend Argon ausgesetzt wird.

2. Verfahren nach Anspruch 1, **dadurch gekennzeichnet, dass** die Zeit zwischen dem Beginn der ersten Wärmebehandlung und dem Ende der dritten Wärmebehandlung nicht größer ist als 320 s.

3. Verfahren nach Anspruch 1 oder Anspruch 2, **dadurch gekennzeichnet, dass** die minimale Temperatur der Substratscheibe

   sowohl zwischen der ersten und der zweiten Wärmebehandlung als auch zwischen der zweiten und der dritten Wärmebehandlung nicht kleiner ist als 600 °C, bevorzugt nicht kleiner ist als 750 °C.

4. Verfahren nach einem der Ansprüche 1 bis 3, **dadurch gekennzeichnet, dass** die Atmosphäre bei der zweiten Wärmebehandlung nicht weniger als 40 % und nicht mehr als 60 % NH$_3$ enthält.

5. Verfahren nach einem der Ansprüche 1 bis 4, **dadurch gekennzeichnet, dass** die Substratscheibe eine Konzentration von interstitiellem Sauerstoff aufweist, die nicht weniger als $4,5 \times 10^{17}$ Atome/cm$^3$ (new ASTM)

   und nicht mehr als $5,2 \times 10^{17}$ Atome /cm$^3$ (new ASTM) aufweist.

6. Verfahren nach einem der Ansprüche 1 bis 5, **dadurch gekennzeichnet, dass** die Substratscheibe von einem Siliciumkristall gewonnen wurde, der mittels des Ziehverfahrens nach Czochralski hergestellt wurde, wobei während des Ziehens der Partialdruck von H$_2$ der Atmosphäre in der Ziehanlage 20 Pa nicht unterschreit.

7. Verfahren nach Anspruch 6, **dadurch gekennzeichnet, dass**

   der Partialdruck von H$_2$ nicht mehr als 50 Pa beträgt.

8. Verfahren nach einem der Ansprüche 1 bis 7, **dadurch gekennzeichnet, dass** die Substratscheibe ein Gebiet P$_i$ aufweist, bei dem Silicium Zwischengitteratome dominieren.

9. Verfahren nach Anspruch 8, **dadurch gekennzeichnet, dass** die Substratscheibe ein Gebiet P$_v$ mit einer Größe von weniger als 30% der Substratscheibe enthält, bei dem Silicium Leerstellen dominieren.

10. Verfahren nach Anspruch 9, **dadurch gekennzeichnet, dass** das Gebiet P$_v$ ein Gebiet P$_{bmd}$ enthält, in dem die Größe von enthaltenen Sauerstoffpräzipitaten nicht mehr als 9 nm, bevorzugt nicht mehr als 6 nm ist.

11. Verfahren nach einem der Ansprüche 1 bis 10, **dadurch gekennzeichnet, dass** die Substratscheibe einen Durchmesser von nicht kleiner als 300 mm aufweist.

Figur 1

Figur 2

Europäisches
Patentamt

European
Patent Office

Office européen
des brevets

## EUROPÄISCHER RECHERCHENBERICHT

Nummer der Anmeldung

EP 20 18 1650

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | EP 3 555 348 A1 (SILTRONIC AG [DE]) 23. Oktober 2019 (2019-10-23) * Absätze [0003], [0015], [0019], [0028], [0030], [0033], [0043], [0044]; Ansprüche 5-7 * ----- | 1-11 | INV. C30B15/00 C30B29/06 C30B33/02 |
| A | DE 10 2014 208815 A1 (SILTRONIC AG [DE]) 12. November 2015 (2015-11-12) * Absätze [0014], [0030]; Ansprüche 1,3 * ----- | 1-11 | |

RECHERCHIERTE
SACHGEBIETE (IPC)

C30B

Der vorliegende Recherchenbericht wurde für alle Patentansprüche erstellt

| Recherchenort | Abschlußdatum der Recherche | Prüfer |
|---|---|---|
| Den Haag | 11. Dezember 2020 | Rausch, Elisabeth |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus anderen Gründen angeführtes Dokument
    ...............................................................
& : Mitglied der gleichen Patentfamilie, übereinstimmendes
    Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 20 18 1650

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

11-12-2020

| Im Recherchenbericht angeführtes Patentdokument | Datum der Veröffentlichung | Mitglied(er) der Patentfamilie | Datum der Veröffentlichung |
|---|---|---|---|
| EP 3555348 A1 | 23-10-2019 | CN 110062824 A<br>DE 102016225138 A1<br>EP 3555348 A1<br>JP 2020502028 A<br>KR 20190084298 A<br>TW 201839190 A<br>US 2020240039 A1<br>WO 2018108735 A1 | 26-07-2019<br>21-06-2018<br>23-10-2019<br>23-01-2020<br>16-07-2019<br>01-11-2018<br>30-07-2020<br>21-06-2018 |
| DE 102014208815 A1 | 12-11-2015 | CN 105097891 A<br>DE 102014208815 A1<br>JP 6293087 B2<br>JP 2015216375 A<br>KR 20150128574 A<br>SG 10201503181V A<br>TW 201542894 A<br>US 2015325433 A1 | 25-11-2015<br>12-11-2015<br>14-03-2018<br>03-12-2015<br>18-11-2015<br>30-12-2015<br>16-11-2015<br>12-11-2015 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 9845508 A1
- US 20020170631 A1
- EP 1887110 A1
- DE 102017219255 A1
- DE 102016225138 A1

**In der Beschreibung aufgeführte Nicht-Patentliteratur**

- **T. MÜLLER et al.** Near-Surface Defect Control by Vacancy Injecting/Out-Diffusing Rapid thermal Annealing. *Phys. Status Solidi A,* 2019, 1900325